# FASCICULE DE BREVET EUROPEEN

(11) **EP 2 498 588 B1**
(45) Date de publication et mention de la délivrance du brevet: **14.06.2017**
(21) Numéro de dépôt: 12354008.0
(22) Date de dépôt: 23.01.2012
(51) Int. Cl.: H02B 1/56, H02B 7/06, H05K 7/20

(54) **Procédé de gestion thermique d'une installation de conversion d'énergie électrique et installation pour mise en oeuvre du procédé**
Verfahren zur thermischen Steuerung einer elektrischen Energieumwandlungsanlage, und Anlage zur Umsetzung dieses Verfahrens
Method for thermal management of an electric power conversion facility and facility for implementing the method

(30) Priorité: 11.03.2011 FR 1100749
(43) Date de publication de la demande: 12.09.2012
(73) Titulaire: Schneider Electric Industries SAS, 92500 Rueil-Malmaison (FR)
(72) Inventeur: Moreau, Julien, 38050 Grenoble Cedex 09 (FR); Radu, Daniel, 38050 Grenoble Cedex 09 (FR)
(74) Mandataire: Tripodi, Paul

(56) Documents cités:
- EP-A1- 2 026 404

## Description

### DOMAINE TECHNIQUE

La présente invention concerne un procédé de fonctionnement ou un procédé de gestion thermique d'une installation de conversion d'énergie électrique. Elle concerne également une installation de conversion d'énergie électrique mettant en oeuvre un tel procédé. Elle concerne enfin un programme informatique comprenant un moyen de code de programme informatique adapté à l'exécution d'étapes du procédé.

### ETAT DE LA TECHNIQUE

L'invention s'applique en particulier à des sous stations d'alimentation en énergie électrique pour des applications industrielles de forte puissance intégrant des dispositifs d'électroniques de puissance.

Dans la plupart des locaux électriques de distribution, équipés de transformateurs et de tableaux moyenne tension et/ou basse tension, on utilise une ventilation forcée qui permet d'évacuer les calories dissipées par l'appareillage. Le document EP2026404 montre ce type de ventilation forcée. Celle-ci est pilotée en fonction de la température interne du local. On prévoit aussi des résistances chauffantes permettant de maintenir un niveau de température acceptable pour les équipements et les problèmes de condensation, au cas où la température extérieure est très faible, et/ou la puissance dissipée par les équipements n'est pas suffisante pour maintenir la température dans le local à un niveau suffisant. Si la ventilation forcée devient insuffisante (conditions climatiques très chaudes, puissance dissipée très importante) on utilise une climatisation afin de maintenir une température acceptable dans le local. Généralement, dans les applications où l'on utilise des dispositifs d'électronique de puissance, comme les centres de stockage de données informatiques par exemple, il est habituel de climatiser les locaux pour dissiper les pertes.

Dans le cas de certains dispositifs d'électronique de puissance, on retrouve aussi l'utilisation d'un fluide caloporteur pour capter les calories au plus prés des interrupteurs statiques, et les évacuer soit directement avec un échangeur à air, soit avec un groupe de production d'eau glacée.

WO-A1-2007/001024 décrit une procédé d'après le préambule de la revendication 1. Ces différentes solutions présentent certains inconvénients:
- les résistances chauffantes, comme la climatisation, sont très consommatrices en énergie électrique et ne correspondent plus aux critères d'efficacité énergétique demandés aujourd'hui ;
- l'utilisation de la climatisation est peu fiable et pose des problèmes de maintenance en plus des coûts d'investissement importants,
- l'utilisation d'un fluide caloporteur nécessite l'emploi d'un réseau de fluide peu compatible avec la proximité d'appareillage électrique.

### EXPOSE DE L'INVENTION

Un premier but de l'invention est de fournir une installation de conversion d'énergie électrique permettant de remédier aux problèmes évoqués précédemment et améliorant les installations connues de l'art antérieur. En particulier, l'invention propose une installation simple, économique et efficace. Un deuxième but de l'invention est de fournir un procédé de fonctionnement d'une installation de conversion permettant d'optimiser le rendement énergétique en minimisant les pertes énergétiques au niveau de l'installation. L'invention concerne un procédé de fonctionnement d'une installation de conversion d'énergie électrique, l'installation comprenant une enceinte dans laquelle sont disposés un convertisseur de tension et un dispositif d'électronique de puissance, ledit procédé de fonctionnement comprend la mise en oeuvre de différents cheminements d'un fluide caloporteur selon l'état de fonctionnement du dispositif d'électronique de puissance et/ou selon l'environnement thermique dans lequel se trouve l'installation.

Dans un mode de réalisation particulier du procédé de fonctionnement, on distingue, dans l'état de fonctionnement du dispositif d'électronique de puissance, un état de marche et un état de veille et/ou en ce qu'on distingue, dans l'environnement thermique, un état thermique haut, notamment lorsque la température de l'environnement est supérieure à un premier seuil, et un état thermique bas, notamment lorsque la température de l'environnement est inférieure au premier seuil.

De préférence, dans le procédé de fonctionnement on met en oeuvre un premier cheminement du fluide caloporteur permettant de dissiper de l'énergie thermique du convertisseur de tension à l'extérieur de l'enceinte lorsque le dispositif d'électronique de puissance est en marche et/ou lorsque l'état thermique de l'environnement est haut.

De préférence, dans le procédé de fonctionnement on met en oeuvre un deuxième cheminement du fluide caloporteur permettant de dissiper de l'énergie thermique du convertisseur de tension dans le dispositif d'électronique de puissance lorsque le dispositif d'électronique de puissance est en veille et lorsque l'état thermique de l'environnement est bas.

De préférence, dans le procédé de fonctionnement on met en oeuvre un troisième cheminement du fluide caloporteur permettant de dissiper de l'énergie thermique du dispositif d'électronique de puissance à l'extérieur de l'enceinte lorsque le dispositif d'électronique de puissance est en marche.

Avantageusement, dans le procédé de fonctionnement on met en oeuvre une recirculation d'une fraction du fluide caloporteur, au niveau du dispositif d'électronique de puissance, dans le troisième cheminement lorsque l'état thermique de l'environnement est bas.

Dans une Installation de conversion d'énergie électrique selon l'invention, comprenant une enceinte munie d'un premier compartiment dans lequel est disposé un convertisseur de tension et munie d'un deuxième compartiment dans lequel est disposé un dispositif d'électronique de puissance, l'installation comprend des moyens matériels et/ou logiciels de mise en oeuvre du procédé de fonctionnement tel que défini ci-dessus.

De préférence, les moyens matériels comprennent une première ouverture entre l'extérieur et le premier compartiment et une deuxième ouverture entre l'extérieur et le premier compartiment, les première et deuxième ouvertures permettant le premier cheminement de fluide caloporteur entre l'extérieur et le convertisseur de tension.

De préférence, les moyens matériels comprennent une troisième ouverture entre l'extérieur et le deuxième compartiment et une quatrième ouverture entre l'extérieur et le deuxième compartiment, les troisième et quatrième ouvertures permettant le troisième cheminement de fluide caloporteur entre l'extérieur et le dispositif d'électronique de puissance.

De préférence, les moyens matériels comprennent une cinquième ouverture entre le premier compartiment et le deuxième compartiment et une sixième ouverture entre le premier compartiment et le deuxième compartiment, les cinquième et sixième ouvertures permettant le deuxième cheminement de fluide caloporteur entre convertisseur de tension et le dispositif d'électronique de puissance.

Avantageusement, les moyens matériels comprennent un faux plancher dans le deuxième compartiment, ledit faux plancher étant apte à canaliser le fluide caloporteur.

Avantageusement, les moyens matériels comprennent une hotte dans le deuxième compartiment, notamment une hotte apte à collecter le fluide caloporteur ayant circulé au niveau du dispositif d'électronique de puissance.

Avantageusement, le convertisseur de tension est du type Moyenne Tension - Basse Tension, en ce que le dispositif d'électronique de puissance est du type Basse Tension.

Avantageusement, le convertisseur de tension est du type Moyenne Tension - Moyenne Tension, en ce que le dispositif d'électronique de puissance est du type Moyenne Tension.

Un programme informatique selon l'invention, comprend un moyen de code de programme informatique adapté à l'exécution d'étapes du procédé ci-dessus lorsque le programme est exécuté sur un ordinateur.

### BREVE DESCRIPTION DES DESSINS

Les dessins annexés représentent, à titre d'exemples, un mode de réalisation d'une installation selon l'invention et un mode d'exécution d'un procédé de fonctionnement selon l'invention.
La figure 1 est un schéma en coupe d'un mode de réalisation d'une installation selon l'invention, l'installation fonctionnant selon un premier mode de fonctionnement.
La figure 2 est un schéma en coupe du mode de réalisation d'une installation selon l'invention, l'installation fonctionnant selon un deuxième mode de fonctionnement.
La figure 3 est un schéma en coupe du mode de réalisation d'une installation selon l'invention, l'installation fonctionnant selon un troisième mode de fonctionnement.
La figure 4 est un schéma en coupe du mode de réalisation d'une installation selon l'invention, l'installation fonctionnant selon un quatrième mode de fonctionnement.
La figure 5 est un ordinogramme d'un mode d'exécution d'un procédé de fonctionnement selon l'invention.

### DESCRIPTION DETAILLEE DE MODES DE REALISATION PREFERES

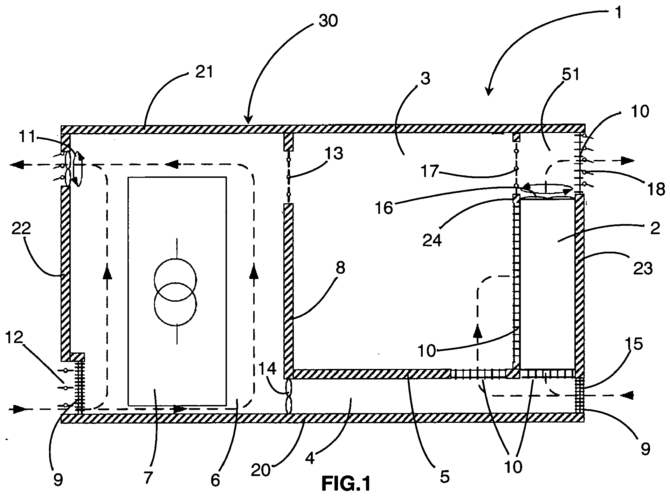

Un mode de réalisation d'une installation selon l'invention est décrit ci-après en référence aux figures 1 à 5.

L'installation est destinée à être placée à l'extérieur. Elle comprend une enceinte, par exemple préfabriquée et éventuellement mobile, dans laquelle sont placés les composants électriques de l'installation. Pour que cette installation puisse être mise en place dans la majorité des zones géographiques, il faut donc que l'installation puisse fonctionner dans une large plage de températures ambiantes (par exemple comprises entre -30 et + 40°C). En dehors de cette plage, il est possible d'utiliser une installation ayant des caractéristiques particulières.

L'installation doit présenter un indice de protection IP élevé pour être insensible à la pluie et pour ne pas brasser des particules pouvant nuire aux composants électriques. L'installation peut être placée à proximité de la mer. Dans ce cas, il faut aussi prévoir des filtres salins pour protéger les composants électriques.

Dans ce type d'installation, les composants les plus sensibles sont les dispositifs d'électronique de puissance. En général, ce type de composant est dimensionné pour fonctionner à des températures comprises entre 0 et +40°C. La limite haute est imposée par la tenue thermique maximale d'interrupteurs statiques. La limite basse est imposée par deux phénomènes différents :
- le comportement des interrupteurs statiques : à basse température, les interrupteurs statiques commutent plus rapidement et engendrent des surtensions qui peuvent être destructrices ;
- les performances du fluide caloporteur interne aux composants sont dégradées à basse température.

Ces phénomènes apparaissent pendant la phase de repos des dispositifs d'électronique de puissance juste avant leur mise en marche. Ensuite, l'auto-échauffement des interrupteurs statiques suffit à éviter ces phénomènes.

On voit donc clairement que, compte tenue des conditions d'exploitations visées, quatre modes de fonctionnement sont nécessaires avec des problématiques contraires :
- en périodes chaudes et en fonctionnement (par exemple +40°C ambiant), il faut que l'air circulant au niveau de l'installation reste inférieur à 40°C ;
- en périodes chaudes et en phase d'arrêt (par exemple +40°C ambiant), il faut que l'air contenu dans l'enceinte reste à une température acceptable pour l'installation (par exemple inférieur à 45°C) ;
- en périodes froides (par exemple -30°C) durant les phases d'arrêt, il faut pouvoir maintenir, ou augmenter, la température dans l'enceinte pour un fonctionnement correct lors du redémarrage.
- en périodes froides (par exemple -30°C) et en fonctionnement, il faut que l'air circulant au niveau de l'installation reste à une température acceptable (par exemple 0°C).

Pour permettre une gestion de l'énergie thermique dans l'installation, l'installation 1 comprend une enceinte 30 ou un local. Ce local comprend une paroi supérieure 21, une paroi inférieure 20 et des parois latérales 22 et 33. Le local comprend un premier compartiment 6 et un deuxième compartiment 3. Le premier compartiment est destiné à recevoir un convertisseur de tension 7. Le deuxième compartiment est destiné à recevoir le dispositif d'électronique de puissance 2. Le premier compartiment 6 est séparé du deuxième compartiment 3 afin que les calories générées par le convertisseur de tension 7 ne viennent pas perturber le refroidissement du dispositif d'électronique de puissance. Par ailleurs, le deuxième compartiment comprend de préférence un faux plancher 5 et/ou une hotte 51 au dessus du dispositif d'électronique de puissance.

On note également que le premier compartiment comprend un ventilateur ou un assemblage de plusieurs ventilateurs 11, permettant de mettre en circulation, selon un premier cheminement, un fluide caloporteur extérieur au local comme de l'air, à l'intérieur du premier compartiment. De cette façon, de l'énergie thermique peut être échangée entre l'intérieur du premier compartiment, notamment entre le convertisseur de tension 7 et l'extérieur du local. Cette circulation de fluide caloporteur est effectuée par une première ouverture 12 munie d'une trappe, dans la paroi latérale 22, et par une deuxième ouverture au niveau du ventilateur 11. Par exemple, si le fluide caloporteur entre dans le premier compartiment au niveau de l'ouverture 12, on équipe cette première ouverture d'un filtre 9. Ainsi, lorsque l'on ouvre la trappe de l'ouverture 12 et que l'on met en marche le ventilateur 11, le fluide caloporteur entre dans le premier compartiment au niveau de l'ouverture 12, circule dans le premier compartiment autour du convertisseur de tension, puis ressort du premier compartiment au niveau de la deuxième ouverture associée au ventilateur 11.

De manière symétrique, le deuxième compartiment comprend un ventilateur 16 permettant de mettre en circulation, selon un cheminement, un fluide caloporteur extérieur au local comme de l'air, à l'intérieur du deuxième compartiment. De cette façon, de l'énergie thermique peut être échangée entre l'intérieur du deuxième compartiment, notamment entre le dispositif d'électronique de puissance 2 et l'extérieur du local. Cette circulation de fluide caloporteur est effectuée par une troisième ouverture 15, dans la paroi latérale 23, et par une quatrième ouverture 18 dans la paroi latérale 23. Par exemple, si le fluide caloporteur entre dans le deuxième compartiment au niveau de l'ouverture 15, on équipe cette ouverture d'un filtre 9. Ainsi, lorsque l'ouverture 18 est ouverte et que l'on met en marche le ventilateur 16, le fluide caloporteur entre dans le deuxième compartiment au niveau de l'ouverture 15, circule dans le deuxième compartiment, autour et dans le dispositif d'électronique de puissance, puis dans la hotte 51, puis ressort du deuxième compartiment au niveau de l'ouverture 18.

Avantageusement, l'ouverture 15 se trouve sous le faux plancher 5 et des ouvertures sont prévues, notamment sous le dispositif d'électronique de puissance, pour permettre au fluide caloporteur de passer du volume sous le faux plancher aux convertisseurs de fréquence et au reste du deuxième compartiment. Par exemple, le ventilateur 16 est monté juste au-dessus du dispositif d'électronique de puissance. De préférence, le fluide caloporteur peut circuler dans le reste du deuxième compartiment après avoir circulé dans le volume sous le faux plancher et avant de circuler autour et dans le dispositif d'électronique de puissance.

En variante, l'ouverture 15 n'est pas directement au niveau du faux plancher, mais se situe sur une ou plusieurs faces externes du deuxième compartiment 3 et permet ainsi une circulation d'air directe entre l'extérieur et l'intérieur du deuxième compartiment 3, et particulièrement dans le cas ou le faux plancher n'existe pas.

En autre variante l'ouverture 15 est fractionné en plusieurs ouvertures: au niveau du faux plancher et sur une ou plusieurs faces externes du deuxième compartiment 3.

Au niveau de la hotte, on prévoit avantageusement une trappe 17 permettant de mettre en communication la hotte et le reste du deuxième compartiment.

Par ailleurs, une cloison 8 sépare les premier et deuxième compartiments. Cette cloison comprend une cinquième ouverture munie d'une trappe 13 et une sixième ouverture associée à un ventilateur 14. De préférence, l'une des cinquième et sixième ouvertures est réalisée entre le premier compartiment et le volume du deuxième compartiment se trouvant sous le faux plancher.

Ainsi, lorsque l'on ouvre la trappe 13 et que l'on met en marche le ventilateur 14, le fluide caloporteur venant du deuxième compartiment entre dans le premier compartiment au niveau de l'ouverture 13, circule dans le premier compartiment autour du convertisseur de tension, puis ressort du premier compartiment au niveau de l'ouverture associée au ventilateur 14 pour retourner dans le deuxième compartiment. Ainsi, on peut réaliser, par un cheminement de fluide caloporteur, un échange thermique entre le convertisseur de tension 7 et le dispositif d'électronique de puissance 2.

Sur les figures, les éléments référencés 9 sont des filtres, notamment des filtres présentant un indice de protection IP élevé et/ou comprenant un filtre salin. Les éléments référencés 10 sont des grilles présentant un indice de protection IP plus faible.

De préférence, les trappes 12, 13 et 17 sont du type motorisé.

La principale contrainte thermique est imposée par le dispositif d'électronique de puissance qui doit être ventilé en permanence avec un fluide caloporteur dont la température ne dépasse pas 40°C. De plus, c'est le dispositif d'électronique de puissance qui génère le plus de pertes thermiques, pour une installation telle que décrite précédemment.

L'installation comprend tous les moyens matériels et/ou logiciels permettant de mettre en oeuvre le procédé de fonctionnement ou de gestion thermique objet de l'invention. En particulier, l'installation comprend des moyens matériels et/ou logiciels permettant de mettre en oeuvre chacune des étapes du procédé objet de l'invention et permettant d'articuler logiquement et/ou temporellement chacune de ces étapes. Bien que non représenté, l'installation comprend une unité logique de traitement permettant de commander différents équipements, notamment les trappes motorisées 12, 13 et 17 et les ventilateurs 11, 16 et 14. Par ailleurs, l'installation comprend avantageusement des capteurs permettant de déterminer l'état de fonctionnement de l'installation, en particulier l'état de fonctionnement du dispositif d'électronique de puissance et des capteurs permettant de déterminer l'état thermique de l'environnement dans lequel se trouve l'installation.

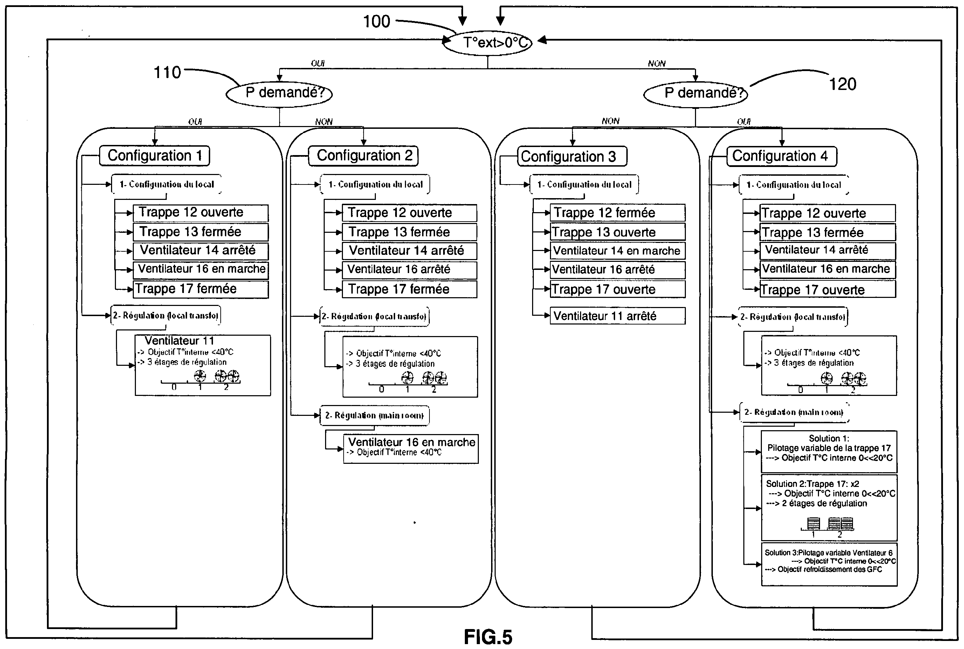

Un mode d'exécution du procédé de fonctionnement de l'installation selon l'invention est décrit ci-après en référence à la figure 5.

Dans une première étape 100, on teste l'état thermique de l'environnement dans lequel se trouve l'installation. Si l'état thermique de l'environnement est haut, on passe une étape 110. Si l'état thermique de l'environnement est bas, on passe à une étape 120. Par exemple, on considère que l'état thermique de l'environnement est haut si la température à l'extérieur de l'enceinte 30 est supérieure à un premier seuil, par exemple 0 °C et que l'état thermique de l'environnement est bas la température à l'extérieur de l'enceinte et inférieure à ce premier seuil.

Dans l'étape 110, on teste si le dispositif d'électronique de puissance est en veille ou en marche. Si le dispositif d'électronique de puissance est en marche, on configure l'installation comme décrit ci-après en référence à la figure 1.

Dans cette configuration, la trappe 12 est ouverte, la trappe 13 est fermée, le ventilateur 14 est arrêté, le ventilateur 16 est en marche et la trappe 17 est fermée. Par ailleurs, le ventilateur 11 peut être activé selon différents niveaux. Tant que la température à l'intérieur du premier compartiment n'est pas trop élevée, le ventilateur 11 peut être à l'arrêt. Il est mis en fonctionnement pour éviter que la température du premier compartiment ne franchisse un seuil, par exemple 40°C. À cette fin, il peut être mis en marche à différents régimes.

Ainsi, dans le premier compartiment, de l'air extérieur à l'enceinte est admis par la trappe 12, circule autour du convertisseur de tension, puis est refoulé à l'extérieur par le ventilateur 11. Ceci permet de refroidir le convertisseur de tension. Dans le deuxième compartiment, de l'air extérieur à l'enceinte est admis par l'ouverture 15, circule autour et dans le dispositif d'électronique de puissance puis est refoulé à l'extérieur par le ventilateur 16 au travers de la trappe 18. Ceci permet de refroidir le dispositif d'électronique de puissance.

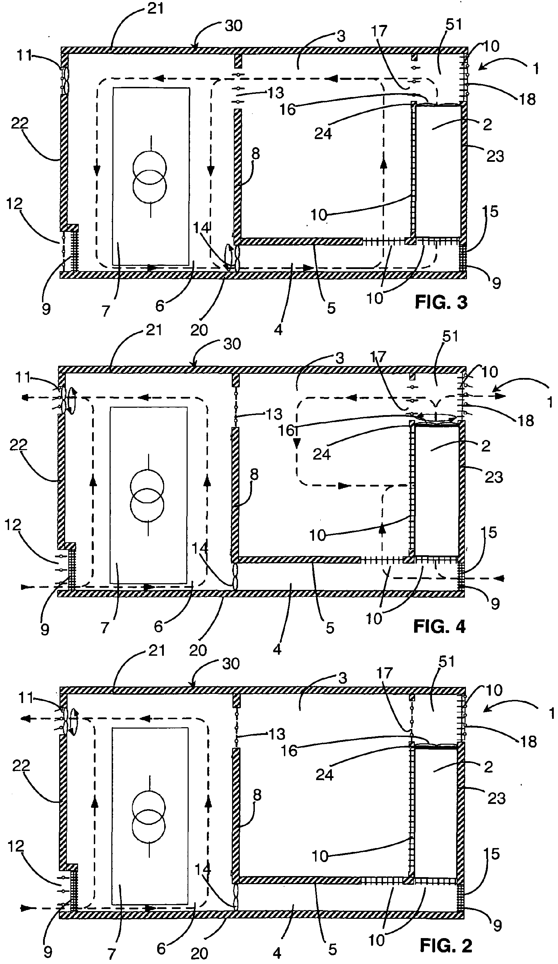

Si le dispositif d'électronique de puissance est en veille, on configure l'installation comme décrit ci-après en référence à la figure 2.

Dans cette configuration, la trappe 12 est ouverte, la trappe 13 est fermée, le ventilateur 14 est arrêté et la trappe 17 est fermée. Par ailleurs, le ventilateur 11 peut être activé selon différents niveaux. Tant que la température à l'intérieur du premier compartiment n'est pas trop élevée, le ventilateur 11 peut être à l'arrêt. Il est mis en fonctionnement pour éviter que la température du local ne franchisse un seuil, par exemple 40°C. À cette fin, il peut être mis en marche à différents régimes. De même, tant que la température à l'intérieur du deuxième compartiment n'est pas trop élevée, le ventilateur 16 peut être à l'arrêt. Il est mis en fonctionnement pour éviter que la température du deuxième compartiment ne franchisse un seuil, par exemple 40°C. À cette fin, il peut être mis en marche à différents régimes.

Ainsi, dans le premier compartiment, de l'air extérieur à l'enceinte est admis par la trappe 12, circule autour du convertisseur de tension, puis est refoulé à l'extérieur par le ventilateur 11. Ceci permet de refroidir le convertisseur de tension. Dans le deuxième compartiment, de l'air extérieur à l'enceinte est admis par l'ouverture 15, circule autour du dispositif d'électronique de puissance puis est refoulé à l'extérieur par le ventilateur 16 au travers de la trappe 18. Ceci permet de refroidir le deuxième compartiment uniquement si la température dans le deuxième compartiment devient trop importante.

Dans l'étape 120, on teste si le dispositif d'électronique de puissance est en veille ou en marche. Si le dispositif d'électronique de puissance est en veille, on configure l'installation comme décrit ci-après en référence à la figure 3.

Dans ce mode de fonctionnement il est nécessaire de maintenir une température acceptable dans l'enceinte particulièrement à proximité du dispositif d'électronique de puissance. Pour cela, dans un souci d'efficacité, l'invention permet d'utiliser les pertes calorifiques du convertisseur de tension 7, resté connecté au réseau, du premier compartiment 6, afin d'augmenter la température du deuxième compartiment 3.

Dans cette configuration, la trappe 12 est fermée, la trappe 13 est ouverte, le ventilateur 14 est en marche, le ventilateur 11 est arrêté et la trappe 17 est ouverte. De préférence, le ventilateur 16 est arrêté, mais peut être utilisé (par exemple à faible débit) pour forcer la circulation du flux d'air dans le dispositif d'électronique de puissance.

Ainsi, dans le premier compartiment, de l'air interne à l'enceinte est admis par la trappe 13 depuis le deuxième compartiment, circule autour du convertisseur de tension et se réchauffe grâce aux pertes calorifiques du convertisseur de tension 7, puis est refoulé dans le deuxième compartiment par le ventilateur 14. L'air réchauffe donc ensuite le dispositif d'électronique de puissance 2. Ceci permet d'utiliser les pertes calorifiques du convertisseur de tension pour réchauffer le dispositif d'électronique de puissance. On réalise ainsi un couplage thermique entre le convertisseur de tension et le dispositif d'électronique de puissance.

Dans cette configuration, pour augmenter l'efficacité de l'installation, on pourrait fermer toutes les entrées d'air (par exemple l'ouverture 15). Au niveau des ouvertures de refoulement 18 et 11, on utilise par exemple des vantelles de surpression.

Si le dispositif d'électronique de puissance est en marche, on configure l'installation comme décrit ci-après en référence à la figure 4.

Dans cette configuration, la trappe 12 est ouverte, la trappe 13 est fermée, le ventilateur 14 est arrêté et la trappe 17 est ouverte. Par ailleurs, le ventilateur 11 peut être activé selon différents niveaux. Tant que la température à l'intérieur du premier compartiment n'est pas trop élevée, le ventilateur 11 peut être à l'arrêt. Il est mis en fonctionnement pour éviter que la température du local ne franchisse un seuil, par exemple 40°C. À cette fin, il peut être mis en marche à différents régimes. Dans le deuxième compartiment, on pilote le ventilateur 16 et/ou la trappe 17 de sorte que la température de l'air circulant autour du dispositif d'électronique de puissance soit par exemple comprise entre 0° et 20 °C. Pour ce faire, le flux d'air extrait du dispositif d'électronique de puissance est décomposé en deux parties : une première qui entre par l'ouverture 15 circule autour et dans le dispositif d'électronique de puissance puis est refoulé à l'extérieur par l'ouverture 18 dans un flux extrait ; une seconde qui circule dans le deuxième compartiment puis dans le dispositif d'électronique de puissance, puis est refoulé dans le deuxième compartiment par la trappe 17 dans un flux de recirculation. Ainsi le mélange de ces deux flux permet de refroidir le dispositif d'électronique de puissance en utilisant l'air externe, tout en conservant une température acceptable pour les composants dans le deuxième compartiment 3.

La température du deuxième compartiment va dépendre de l'équilibre entre le flux extrait et le flux de recirculation. Pour réguler l'équilibre de ces flux trois solutions sont envisageables.

Une première solution consiste à piloter l'ouverture de la trappe 17 et donc la perte de charge au niveau de la trappe 17, la différence entre les pertes de charge au niveau de la trappe 17 et les pertes de charge au niveau de la trappe 18 fixant le taux de recirculation.

Une deuxième solution consiste à réaliser la trappe 17 en plusieurs éléments pouvant être commandés en ouverture indépendamment les uns des autres. On obtient ainsi plusieurs étages de régulation.

Une troisième solution consiste à ouvrir la trappe 17 et à piloter le régime du ventilateur 16. La trappe 17 étant ouverte et la trappe 18 s'ouvrant en fonction de la pression régnant dans la hotte, il est possible de faire recirculer plus ou moins d'air en fonction du régime du ventilateur 16.

Ainsi, dans le premier compartiment, de l'air extérieur à l'enceinte est admis par la trappe 12, circule autour du convertisseur de tension, puis est refoulé à l'extérieur par le ventilateur 11. Ceci permet de refroidir le convertisseur de tension. Dans le deuxième compartiment, de l'air extérieur à l'enceinte est admis par l'ouverture 15, circule autour et dans le dispositif d'électronique de puissance puis est partiellement refoulé à l'extérieur par le ventilateur 16 au travers de la trappe 18 et partiellement contraint à recirculer dans le deuxième compartiment et autour du dispositif d'électronique de puissance. Ceci permet de refroidir le dispositif d'électronique de puissance tout en conservant une température acceptable dans le deuxième compartiment.

Dans d'autres modes de réalisation non représentés sur les figures les moyens matériels comprennent une ouverture directe entre le deuxième compartiment et l'extérieur de l'enceinte en supplément du flux passant par le faux plancher. De même, les moyens matériels peuvent avoir au moins une ouverture directe entre le deuxième compartiment et l'extérieur de l'enceinte sans la présence de faux plancher.

## Revendications

1. Procédé de fonctionnement d'une installation (1) de conversion d'énergie électrique, l'installation comprenant une enceinte (30) dans laquelle sont disposés un convertisseur de tension (7) et un dispositif d'électronique de puissance (2), ledit procédé de fonctionnement **caractérisé en ce**
- **qu'**il comprend la mise en oeuvre de différents cheminements d'un fluide caloporteur selon l'état de fonctionnement du dispositif d'électronique de puissance et/ou selon l'environnement thermique dans lequel se trouve l'installation.
- **qu'**on distingue, dans l'état de fonctionnement du dispositif d'électronique de puissance, un état de marche et un état de veille et/ou en ce qu'on distingue, dans l'environnement thermique, un état thermique haut, notamment lorsque la température de l'environnement est supérieure à un premier seuil, et un état thermique bas, notamment lorsque la température de l'environnement est inférieure au premier seuil,
- **qu'**on met en oeuvre un premier cheminement du fluide caloporteur permettant de dissiper de l'énergie thermique du convertisseur de tension à l'extérieur de l'enceinte lorsque le dispositif d'électronique de puissance est en marche et/ou lorsque l'état thermique de l'environnement est haut, et
- **qu'**on met en oeuvre un deuxième cheminement du fluide caloporteur permettant de dissiper de l'énergie thermique du convertisseur de tension dans le dispositif d'électronique de puissance lorsque le dispositif d'électronique de puissance est en veille et lorsque l'état thermique de l'environnement est bas.

2. Procédé de fonctionnement selon la revendication 1, **caractérisé en ce qu'**on met en oeuvre un troisième cheminement du fluide caloporteur permettant de dissiper de l'énergie thermique du dispositif d'électronique de puissance à l'extérieur de l'enceinte lorsque le dispositif d'électronique de puissance est en marche.

3. Procédé de fonctionnement selon la revendication précédente, **caractérisé en ce qu'**on met en oeuvre une recirculation d'une fraction du fluide caloporteur, au niveau du dispositif d'électronique de puissance, dans le troisième cheminement lorsque l'état thermique de l'environnement est bas.

4. Installation (1) de conversion d'énergie électrique, comprenant une enceinte (30) munie d'un premier compartiment (6) dans lequel est disposé un convertisseur de tension (7) et munie d'un deuxième compartiment (3) dans lequel est disposé un dispositif d'électronique de puissance (2), l'installation **caractérisée en ce qu'**elle comprend des moyens matériels (11, 12, 13, 14, 15, 16, 17, 18) et/ou logiciels de mise en oeuvre du procédé de fonctionnement selon l'une des revendications précédentes.

5. Installation (1) selon la revendication précédente, **caractérisée en ce que** les moyens matériels comprennent une première ouverture entre l'extérieur et le premier compartiment et une deuxième ouverture entre l'extérieur et le premier compartiment, les première et deuxième ouvertures permettant le premier cheminement de fluide caloporteur entre l'extérieur et le convertisseur de tension.

6. Installation (1) selon la revendication 4 ou 5, **caractérisée en ce que** les moyens matériels comprennent une troisième ouverture entre l'extérieur et le deuxième compartiment et une quatrième ouverture entre l'extérieur et le deuxième compartiment, les troisième et quatrième ouvertures permettant le troisième cheminement de fluide caloporteur entre l'extérieur et le dispositif d'électronique de puissance.

7. Installation (1) selon l'une des revendications 4 à 6, **caractérisée en ce que** les moyens matériels comprennent une cinquième ouverture entre le premier compartiment et le deuxième compartiment et une sixième ouverture entre le premier compartiment et le deuxième compartiment, les cinquième et sixième ouvertures permettant le deuxième cheminement de fluide caloporteur entre convertisseur de tension et le dispositif d'électronique de puissance.

8. Installation (1) selon l'une des revendications 4 à 7, **caractérisée en ce que** les moyens matériels comprennent un faux plancher (5) dans le deuxième compartiment, ledit faux plancher étant apte à canaliser le fluide caloporteur.

9. Installation (1) selon l'une des revendications 4 à 8, **caractérisée en ce que** les moyens matériels comprennent une hotte (51) dans le deuxième compartiment, notamment une hotte apte à collecter le fluide caloporteur ayant circulé au niveau du dispositif d'électronique de puissance.

10. Installation (1) selon l'une des revendications 4 à 9, **caractérisée en ce que** le convertisseur de tension (7) est du type Moyenne Tension - Basse Tension, **en ce que** le dispositif d'électronique de puissance est du type Basse Tension.

11. Installation (1) selon l'une des revendications 4 à 9, **caractérisée en ce que** le convertisseur de tension (7) est du type Moyenne Tension - Moyenne Tension, **en ce que** le dispositif d'électronique de puissance est du type Moyenne Tension.

12. Programme informatique comprenant un moyen de code de programme informatique adapté à l'exécution d'étapes du procédé selon l'une des revendications 1 à 3, lorsque le programme est exécuté sur un ordinateur.

## Patentansprüche

1. Betriebsverfahren einer Anlage (1) zur Umwandlung elektrischer Energie, wobei die Anlage eine Hülle (30) umfasst, in welcher ein Spannungswandler (7) und eine Leistungselektronikvorrichtung (2) angeordnet sind, wobei das Betriebsverfahren **dadurch gekennzeichnet ist,**
- **dass** es die Benutzung verschiedener Fließwege eines Wärmeträgerfluids je nach dem Betriebszustand der Leistungselektronikvorrichtung und/oder je nach der thermischen Umgebung, in der sich die Anlage befindet, umfasst,
- **dass** beim Betriebszustand der Leistungselektronikvorrichtung ein Arbeitszustand und ein Bereitschaftszustand unterschieden werden, und/oder dass bei der thermischen Umgebung ein hoher thermischer Zustand, insbesondere wenn die Temperatur der Umgebung höher als ein erster Schwellenwert ist, und ein niedriger thermischer Zustand, insbesondere wenn die Temperatur der Umgebung niedriger als der erste Schwellenwert ist, unterschieden werden,
- **dass** ein erster Fließweg des Wärmeträgerfluids benutzt wird, der es ermöglicht, thermische Energie des Spannungswandlers aus der Hülle hinaus abzuführen, wenn sich die Leistungselektronikvorrichtung im Arbeitszustand befindet und/oder wenn der thermische Zustand der Umgebung hoch ist, und
- **dass** ein zweiter Fließweg des Wärmeträgerfluids benutzt wird, der es ermöglicht, thermische Energie des Spannungswandlers in der Leistungselektronikvorrichtung abzuführen, wenn sich die Leistungselektronikvorrichtung im Bereitschaftszustand befindet und wenn der thermische Zustand der Umgebung niedrig ist.

2. Betriebsverfahren nach Anspruch 1, **dadurch gekennzeichnet, dass** ein dritter Fließweg des Wärmeträgerfluids benutzt wird, der es ermöglicht, thermische Energie der Leistungselektronikvorrichtung aus der Hülle hinaus abzuführen, wenn sich die Leistungselektronikvorrichtung im Arbeitszustand befindet.

3. Betriebsverfahren nach dem vorhergehenden Anspruch, **dadurch gekennzeichnet, dass** beim dritten Fließweg eine Rezirkulation eines Teils des Wärmeträgerfluids an der Leistungselektronikvorrichtung durchgeführt wird, wenn der thermische Zustand der Umgebung niedrig ist.

4. Anlage (1) zur Umwandlung elektrischer Energie, welche eine Hülle (30) umfasst, die mit einer ersten Kammer (6) ausgestattet ist, in der ein Spannungswandler (7) angeordnet ist, und mit einer zweiten Kammer (3) ausgestattet ist, in der eine Leistungselektronikvorrichtung (2) angeordnet ist, wobei die Anlage **dadurch gekennzeichnet ist, dass** sie Hardwaremittel (11, 12, 13, 14, 15, 16, 17, 18) und/oder Softwaremittel zur Durchführung des Betriebsverfahrens nach einem der vorhergehenden Ansprüche umfasst.

5. Anlage (1) nach dem vorhergehenden Anspruch, **dadurch gekennzeichnet, dass** die Hardwaremittel eine erste Öffnung zwischen der Außenseite und der ersten Kammer und eine zweite Öffnung zwischen der Außenseite und der ersten Kammer umfassen, wobei die erste und die zweite Öffnung den ersten Fließweg des Wärmeträgerfluids zwischen der Außenseite und dem Spannungswandler ermöglichen.

6. Anlage (1) nach Anspruch 4 oder 5, **dadurch gekennzeichnet, dass** die Hardwaremittel eine dritte Öffnung zwischen der Außenseite und der zweiten Kammer und eine vierte Öffnung zwischen der Außenseite und der zweiten Kammer umfassen, wobei die dritte und die vierte Öffnung den dritten Fließweg des Wärmeträgerfluids zwischen der Außenseite und der Leistungselektronikvorrichtung ermöglichen.

7. Anlage (1) nach einem der Ansprüche 4 bis 6, **dadurch gekennzeichnet, dass** die Hardwaremittel eine fünfte Öffnung zwischen der ersten Kammer und der zweiten Kammer und eine sechste Öffnung zwischen der ersten Kammer und der zweiten Kammer umfassen, wobei die fünfte und die sechste Öffnung den zweiten Fließweg des Wärmeträgerfluids zwischen dem Spannungswandler und der Leistungselektronikvorrichtung ermöglichen.

8. Anlage (1) nach einem der Ansprüche 4 bis 7, **dadurch gekennzeichnet, dass** die Hardwaremittel einen Zwischenboden (5) in der zweiten Kammer umfassen, wobei der Zwischenboden geeignet ist, das Wärmeträgerfluid zu kanalisieren.

9. Anlage (1) nach einem der Ansprüche 4 bis 8, **dadurch gekennzeichnet, dass** die Hardwaremittel einen Abzug (51) in der zweiten Kammer umfassen, insbesondere einen Abzug, der geeignet ist, das Wärmeträgerfluid zu sammeln, das an der Leistungselektronikvorrichtung zirkuliert hat.

10. Anlage (1) nach einem der Ansprüche 4 bis 9, **dadurch gekennzeichnet, dass** der Spannungswandler (7) vom Typ Mittelspannung - Niederspannung ist, und dadurch, dass die Leistungselektronikvorrichtung vom Typ Niederspannung ist.

11. Anlage (1) nach einem der Ansprüche 4 bis 9, **dadurch gekennzeichnet, dass** der Spannungswandler (7) vom Typ Mittelspannung - Mittelspannung ist, und dadurch, dass die Leistungselektronikvorrichtung vom Typ Mittelspannung ist.

12. Computerprogramm, das Computerprogrammcodemittel umfasst, die dafür ausgelegt sind, Schritte des Verfahrens nach einem der Ansprüche 1 bis 3 auszuführen, wenn das Programm auf einem Computer ausgeführt wird.

## Claims

1. Method for operating an electrical energy conversion installation (1), the installation comprising a chamber (30) in which are arranged a voltage converter (7) and a power electronic device (2), said operating method **characterized in that**
- it comprises the implementation of different routings of a heat transfer fluid according to the state of operation of the power electronic device and/or according to the thermal environment in which the installation is located,
- there are distinguished, in the state of operation of the power electronic device, an on state and a standby state and/or there are distinguished, in the thermal environment, a high thermal state, notably when the temperature of the environment is above a first threshold, and a low thermal state, notably when the temperature of the environment is below the first threshold,
- a first routing of the heat transfer fluid is implemented that makes it possible to dissipate the thermal energy from the voltage converter outside of the chamber when the power electronic device is on and/or when the thermal state of the environment is high, and
- a second routing of the heat transfer fluid is implemented that makes it possible to dissipate the thermal energy from the voltage converter in the power electronic device when the power electronic device is on standby and when the thermal state of the environment is low.

2. Operating method according to Claim 1, **characterized in that** a third routing of the heat transfer fluid is implemented that makes it possible to dissipate the thermal energy from the power electronic device outside of the chamber when the power electronic device is on.

3. Operating method according to the preceding claim, **characterized in that** a recirculation of a fraction of the heat transfer fluid is implemented, at the level of the power electronic device, in the third routing when the thermal state of the environment is low.

4. Electrical energy conversion installation (1), comprising a chamber (30) provided with a first compartment (6) in which is arranged a voltage converter (7) and provided with a second compartment (3) in which is arranged a power electronic device (2), the installation being **characterized in that** it comprises hardware means (11, 12, 13, 14, 15, 16, 17, 18) and/or software means for implementing the operating method according to one of the preceding claims.

5. Installation (1) according to the preceding claim, **characterized in that** the hardware means comprise a first aperture between the outside and the first compartment and a second aperture between the outside and the first compartment, the first and second apertures allowing the first routing of heat transfer fluid between the outside and the voltage converter.

6. Installation (1) according to Claim 4 or 5, **characterized in that** the hardware means comprise a third aperture between the outside and the second compartment and a fourth aperture between the outside and the second compartment, the third and fourth apertures allowing the third routing of heat transfer fluid between the outside and the power electronic device.

7. Installation (1) according to one of Claims 4 to 6, **characterized in that** the hardware means comprise a fifth aperture between the first compartment and the second compartment and a sixth aperture between the first compartment and the second compartment, the fifth and sixth apertures allowing the second routing of heat transfer fluid between the voltage converter and the power electronic device.

8. Installation (1) according to one of Claims 4 to 7, **characterized in that** the hardware means comprise a raised floor (5) in the second compartment, said raised floor being capable of channelling the heat transfer fluid.

9. Installation (1) according to one of Claims 4 to 8, **characterized in that** the hardware means comprise a hood (51) in the second compartment, notably a hood capable of collecting the heat transfer fluid having circulated at the level of the power electronic device.

10. Installation (1) according to one of Claims 4 to 9, **characterized in that** the voltage converter (7) is of the medium voltage-low voltage type, **in that** the power electronic device is of the low voltage type.

11. Installation (1) according to one of Claims 4 to 9, **characterized in that** the voltage converter (7) is of the medium voltage-medium voltage type, **in that** the power electronic device is of the medium voltage type.

12. Computer program comprising a computer program code means suitable for executing steps of the method according to one of Claims 1 to 3, when the program is run on a computer.
